# EUROPÄISCHE PATENTSCHRIFT

(11) **EP 3 207 776 B1**
(45) Veröffentlichungstag und Bekanntmachung des Hinweises auf die Patenterteilung: **03.04.2019**
(21) Anmeldenummer: 15781053.2
(22) Anmeldetag: 06.10.2015
(51) Int. Cl.: H01R 12/71, H05K 7/14

(54) **ANORDNUNG ZUR FESTLEGUNG WENIGSTENS EINER ERWEITERUNGSKARTE UND SERVERSYSTEM**
ARRANGEMENT FOR FIXING AT LEAST ONE EXPANSION CARD AND SERVER SYSTEM
DISPOSITIF DE FIXATION D'AU MOINS UNE CARTE D'EXTENSION ET SYSTÈME DE SERVEUR

(30) Priorität: 13.10.2014 DE 102014114790
(43) Veröffentlichungstag der Anmeldung: 23.08.2017
(73) Patentinhaber: FUJITSU LIMITED, Kawasaki-shi Kanagawa 211-8588 (JP)
(72) Erfinder: HESSE, Ronny, 33175 Bad Lippspringe (DE); BLUME, Johannes, 33034 Brakel (DE)
(74) Vertreter: Epping - Hermann - Fischer
(86) Internationale Anmeldenummer: PCT/EP2015/073049
(87) Internationale Veröffentlichungsnummer: WO 2016/058868

(56) Entgegenhaltungen:
- US-A1- 2005 030 720
- US-A1- 2005 257 232
- US-A1- 2011 128 687
- US-A1- 2013 027 875

## Beschreibung

Die Erfindung betrifft eine Anordnung zur Festlegung wenigstens einer Erweiterungskarte an oder in einem Servermodul mit einem halboffenen Chassis. Des Weiteren betrifft die Erfindung ein Serversystem umfassend ein Trägerchassis zur Aufnahme einer Mehrzahl von Modulen mit halboffenem Chassis.

Aus dem Stand der Technik sind viele Anordnungen zur Festlegung von Erweiterungskarten bekannt. Insbesondere ist es bekannt, Erweiterungskarten gemäß unterschiedlichen Formfaktoren und Anschlüssen, wie beispielsweise gemäß der Industry Standard Architecture (ISA), dem Vesa Local (VL) Bus, dem Peripheral Component Interconnect (PCI) bzw. dem PCI-Express (PCIe) Standard, mit entsprechenden Steckverbindern einer Systemplatine eines Personal-Computers elektrisch zu verbinden und mittels eines Slotwinkels an einem Slotfeld des Computers mechanisch zu befestigen.

Um die Rechendichte von Computersystemen weiter zu erhöhen, sind weitere Bauformen für Computersysteme, insbesondere Serversysteme, aus dem Stand der Technik bekannt. Beispielsweise sind aus dem Stand der Technik Servermodule mit einem halboffenen Chassis bekannt, die in entsprechende Aufnahmeöffnungen eines Trägerchassis eingeführt werden können. Wegen ihres teilweise offenen Gehäuses werden solche Systeme auf Englisch auch als "Skinless Server" bezeichnet.

Aufgrund der hohen Komponentendichte ist es bei derartigen Serversystemen gar nicht oder nur im beschränkten Umfang möglich, Erweiterungskarten aufzunehmen. Insbesondere können diese nicht direkt, das heißt senkrecht, auf eine Systemplatine des Servermoduls gesteckt werden, weil hierzu der zur Verfügung stehende Bauraum nicht ausreicht. Sofern dennoch eine Montage einzelner, besonders kleiner oder versetzt angeordneter Erweiterungskarten vorgesehen ist, erfordert deren Festlegung an dem Servermodul regelmäßig erheblichen Aufwand.

Aus der US 2013/0027875 A1 ist ein Riser-Kartenmodul mit einem Rahmenkörper bekannt. Das Riser-Kartenmodul weist eine mit dem Rahmenkörper verbundene Trägerplatte zur Anlage an ersten Oberflächen von Positionierungsplatten von Befestigungswinkeln von Erweiterungskarten, eine an dem Rahmenkörper angeordnete Riser-Karte mit mehreren Erweiterungsschlitzen und eine Begrenzungseinheit auf, die relativ zur Trägerplatte um eine axiale Richtung drehbar ist, um die Bewegung der Erweiterungskarten relativ zur Riserkarte zu beschränken.

Die US 2011/0128687 A1 offenbart ein Computersystem umfassend ein Gehäuse, das ein Fenster definiert, eine Abdeckung, die schwenkbar an dem Gehäuse angebracht ist, eine an einem Boden der Abdeckung befestigte Halterung, ein an einer Unterseite der Halterung befestigtes Schienenpaar und eine zwischen den beiden Schienen verschiebbar gehaltene Festplatte. Die Abdeckung kann in eine geöffnete Position geschwenkt werden, um die Festplatte an einen Ort außerhalb des Gehäuses zu bringen, an dem die Festplatte zugänglich ist. Die Abdeckung kann weiter in eine geschlossene Position geschwenkt werden, um das Fenster abzudecken und um dadurch die Festplatte innerhalb des Gehäuses aufzunehmen.

Die US 2005/0257232 A1 bezieht sich auf eine Gehäusekonstruktion eines elektronischen Geräts, wie z. B. eine Rackmount-Disk-Array-Vorrichtung, und ihre Aufgabe besteht darin, die Anzahl der zu montierenden Geräteeinheiten zu erhöhen und deren Austausch zu erleichtern. Die darin offenbarte Gehäusestruktur einer elektronischen Einrichtung umfasst eine Einfassung, die in einem Gestell in einer herausziehbaren Weise montiert so angeordnet ist, dass sie eine Mehrzahl von Verdrahtungspaneelabschnitten umfasst, die den Innenraum der Einfassung in der Vorwärts- und Rückwärtsrichtung unterteilen, wobei die Vielzahl von Verdrahtungspaneelabschnitten so angeordnet ist, dass sie sich über die inneren Oberflächenabschnitte des Gehäuses erstrecken; und einen beweglichen Rahmenabschnitt, der mit den Verdrahtungspaneelabschnitten verbundenen Geräteeinheiten drehend mit den Verdrahtungspaneelabschnitten bewegt, wobei der bewegliche Rahmenteil den Geräteeinheiten derart stützt, dass er an den Verdrahtungspaneelabschnitten anbringbar und von diesen lösbar ist.

Die US 2005/0030720 A1 offenbart einen Montagerahmen, der sich in einem Computerschrank-Ausrüstungsschublade befindet und in eine Ladeposition überführt werden kann, um ein elektrisches Gerät aufzunehmen. Der Montagerahmen in der Ladeposition bietet ausreichend Platz zum Anschließen oder Entfernen des elektrischen Geräts. Der Montagerahmen kann auch in eine Betriebsposition zurückgezogen werden. Der zurückgezogene Montagerahmen ermöglicht es, das elektrische Gerät in einer dichten Anordnung mit minimalem Abstand zwischen elektrischen Geräten zu positionieren. Die Anordnung ermöglicht es, dass die elektrischen Geräte im laufenden Betrieb austauschbar sind, während sie immer noch dicht angeordnet sind.

Es ist eine Aufgabe der vorliegenden Erfindung, eine Befestigungsanordnung für ein Servermodule mit einem halboffenen Chassis zu beschreiben, die eine besonders einfache und flexible Festlegung von einer oder mehrerer Erweiterungskarten gestatten. Bevorzugt soll sich die Anordnung zur werkzeugfreien Montage eignen.

Gemäß einem ersten Aspekt der Erfindung wird eine Anordnung zur Festlegung einer Erweiterungskarte gemäß Anspruch 1 offenbart. Die Anordnung weist ein erstes halboffenes Chassis zur Aufnahme einer ersten Leiterplatte eines Servermoduls mit wenigstens einem ersten Steckverbinder auf. Die Anordnung weist des Weiteren eine Komponente in Form einer Trägerkomponente zur Aufnahme wenigstens einer internen Erweiterungskarte oder eines zweiten halboffenen Chassis zur Aufnahme wenigstens einer externen Erweiterungkarte auf, wobei die Komponente wenigstens einen Befestigungspunkt zur lösbaren und drehbaren Aufnahme der Trägerkomponente in bzw. an dem ersten halboffenen Chassis und wenigstens eine erste Auflagefläche zur Abstützung der Komponente an einer zweiten Auflagefläche des ersten halboffenen Chassis aufweist. Der Befestigungspunkt und die erste Auflagefläche sind im Bereich gegenüberliegender Enden der Komponente angeordnet. Die Anordnung weist des Weiteren wenigstens eine an der Komponente befestigte zweite Leiterplatte mit wenigstens einem ersten Gegensteckverbinder zur elektrischen Kontaktierung des ersten Steckverbinders und wenigstens einem zweiten Steckverbinder zur elektrischen
Kontaktierung eines zweiten Gegensteckverbinders der internen bzw. externen Erweiterungskarte auf. Dabei ist der erste Gegensteckverbinder im Bereich des Endes der Komponente angeordnet, in dem sich die erste Auflagefläche befindet, so dass die zweite Leiterplatte durch Aufnahme und Verschwenken der Komponente um den Befestigungspunkt in Richtung der zweiten Auflagefläche elektrisch mit der ersten Leiterplatte verbunden wird.

Die Anordnung gemäß dem ersten Aspekt kombiniert eine mechanische Trägerkomponente, die durch einseitiges Ansetzen an einem Befestigungspunkt und Verschwenken um eine dort angeordnete drehbare Aufnahme auf einfache Weise an oder in einem halboffenen Chassis festgelegt werden kann. Dabei wird über die zweite Leiterplatte zugleich eine elektrische Verbindung zwischen einer aufzunehmenden Erweiterungskarte und einer Leiterplatte eines halboffenen Chassis hergestellt, so dass elektrischer und mechanischer Anschluss in einem Arbeitsgang erfolgen können. In Verbindung mit der Aufnahme des halboffenen Chassis des Servermoduls in einem Trägerchassis kann in den meisten Fällen auf eine weitere Befestigung der Erweiterungskarte, der Trägerkomponente oder der zweiten Leiterplatte verzichtet werden, so dass eine werkzeugfreie Montage grundsätzlich möglich ist.

In wenigstens einer Ausgestaltung ist die lösbare und drehbare Aufnahme durch eine in einem Aufnahmeschuh angeordnete Drehachse verwirklicht. Eine derartige Anordnung ist einfach herzustellen und ermöglicht eine mechanisch sichere Befestigung der Trägerkomponente an oder in dem halboffenen Chassis.

Für den ersten Steckverbinder und Gegensteckverbinder eignen sich insbesondere Kartenrandstecker bzw. Goldfingerkontakte. Der zweite Steckverbinder eignet sich insbesondere zur Aufnahme von Erweiterungskarten gemäß dem PCIe-Standard.

In wenigstens einer Ausgestaltung weist die zweite Leiterplatte wenigstens einen dritten Steckverbinder zur Kontaktierung eines dritten Gegensteckverbinders einer dritten Leiterplatte zur Stromversorgung der wenigstens einen Erweiterungskarte unabhängig von der ersten Leiterplatte auf. Beispielsweise kann die zweite Leiterplatte direkt eine sogenannte Backplane oder Midplane eines Trägerchassis für das Servermodul kontaktieren, um Erweiterungskarten mit einer hohen Leistungsaufnahme unabhängig von dem Servermodul mit einer Betriebsspannung zu versorgen.

Optional kann die Trägerkomponente im Bereich der ersten Auflagefläche in dem verschwenkten Zustand durch eine Schraube an dem halboffenen Chassis gesichert werden.

Die beschriebene Anordnung eignet sich sowohl zur Festlegung von externen Erweiterungskarten zumindest teilweise außerhalb des halboffenen Chassis als auch zur Aufnahme von internen Erweiterungskarten im Inneren eines halboffenen Chassis.

Insbesondere im Fall von externen Erweiterungskarten kann die Trägerkomponente selbst als halboffenes, insbesondere U-förmiges, Erweiterungschassis ausgestaltet werden, das die wenigstens eine Erweiterungskarte zumindest teilweise umgibt. Durch diese Anordnung ist die Erweiterung eines Servermoduls auf benachbarte Aufnahmepositionen eines Trägerchassis möglich, wobei die halboffene Bauweise des Servermoduls die mechanische und elektrische Festlegung der Erweiterungskarte in einem Chassis des Erweiterungsmoduls gestattet.

Gemäß einem zweiten Aspekt wird ein Serversystem beschrieben, das ein Trägerchassis zur Aufnahme einer Mehrzahl von Modulen, insbesondere Servermodule und Erweiterungsmodule, aufweist. Das Serversystem weist eine in dem Trägerchassis aufgenommene Leiterplatte zur elektrischen Kontaktierung der Mehrzahl von Modulen, wenigstens ein in dem Trägerchassis aufgenommenes Servermodul mit einem ersten halboffenen Chassis und wenigstens ein in dem Trägerchassis aufgenommenes Erweiterungsmodul mit einem zweiten halboffenen Chassis auf. Dabei ist in dem Erweiterungsmodul wenigstens eine Erweiterungskarte für das Servermodul angeordnet, wobei das zweite halboffene Chassis des Erweiterungsmoduls verschwenkbar an dem ersten halboffenen Chassis des Servermoduls festgelegt ist.

Das genannte Serversystem erlaubt eine einfache elektrische und mechanische Festlegung eines Erweiterungsmoduls an einem Servermodul.

Weitere vorteilhafte Ausgestaltungen sind in den abhängigen Patentansprüchen sowie der nachfolgenden Beschreibung unterschiedlicher Ausführungsbeispiele angegeben.

Die Erfindung wird nachfolgend unter Bezugnahme auf die Figuren 1 bis 5 anhand zweier Ausführungsbeispiele im Detail beschrieben. In den Figuren zeigen:
- Figur 1: ein Servermodul mit einem halboffenen Chassis,
- Figuren 2 und 3: die Montage eines Erweiterungsmoduls für externe Erweiterungskarten gemäß einem ersten Ausführungsbeispiel und
- Figuren 4 und 5: die Demontage einer internen Erweiterungskarte gemäß einem zweiten Ausführungsbeispiel.

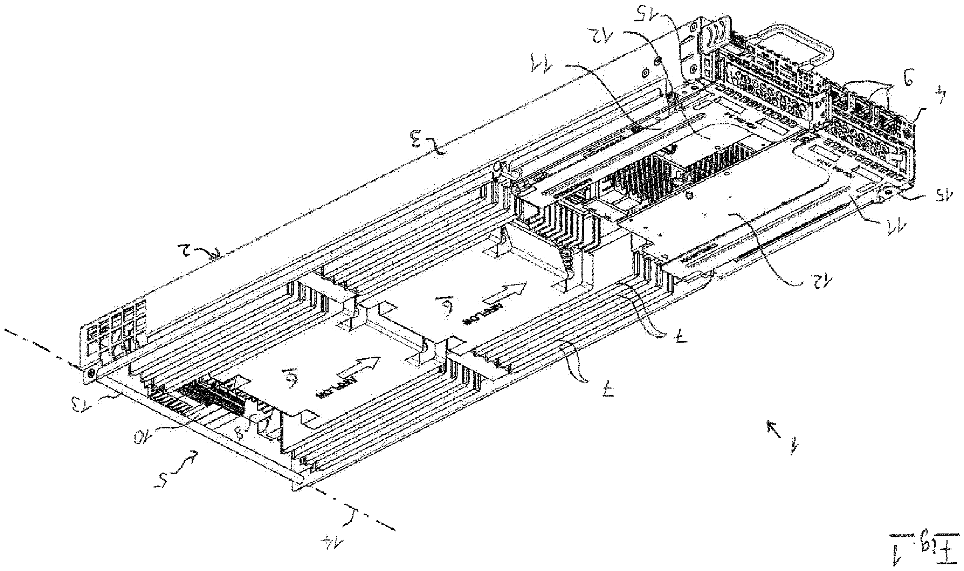

Figur 1 zeigt ein Servermodul 1, das zur Aufnahme in einem in den Figuren nicht dargestellten Trägerchassis geeignet ist. Das Servermodul 1 weist ein halboffenes Chassis 2 aus Stahlblech oder einem anderen geeigneten Material auf. Im Ausführungsbeispiel handelt es sich bei dem halboffenen Chassis 2 um ein im Wesentlichen U-förmiges Blechteil. Das Chassis 2 umgibt in dem Servermodul 1 aufgenommene Komponenten mittels einer in der Figur 1 verdeckten Bodenwand und zwei gegenüberliegenden Seitenwänden 3. Nach oben sowie in Richtung einer Vorderseite 4 sowie einer Rückseite 5 ist das Chassis 2 dagegen weitgehend frei zugänglich. Eine elektrische Schirmung in diesen Bereichen wird teilweise durch eine Anordnung des Servermoduls 1 in einem Trägerchassis und teilweise durch ein Einsetzen weiterer Komponenten und Module in das Chassis 2 oder benachbarter Aufnahmeplätze des Trägerchassis sichergestellt.

Solche Systeme werden im englischen Sprachgebrauch auch als "Skinless Server" bezeichnet, da das Servermodul 1 selbst nur ein unvollständiges Gehäuse aufweist. In der vorliegenden Anmeldung wird dabei jedes Chassis als halboffen bezeichnet, das keine vollständige elektrische Schirmung ermöglicht beziehungsweise Öffnungen aufweist, die eine direkte Kontaktierung von innerhalb des Chassis angeordneter Leiterplatten oder sonstiger Komponenten ermöglichen.

Das Servermodul 1 gemäß Figur 1 weist verschiedene Komponenten eines Servercomputers auf. In der Darstellung gemäß Figur 1 sind zwei Kühlvorrichtungen 6 für darunter angeordnete Prozessoren, insgesamt sechzehn Speichermodule 7 sowie weitere, auf einer ersten Leiterplatte 8 angeordnete Systemkomponenten zu erkennen. Entsprechend wird die erste Leiterplatte 8 auch als Systemplatine oder Mainboard bezeichnet. Auf der ersten Leiterplatte 8 sind des Weiteren von außerhalb des Chassis 2 zugängliche Anschlüsse 9 zum Anschluss des Servermoduls 1 an externe Vorrichtungen, insbesondere Netzwerkswitches und ähnliche Kommunikationseinrichtungen, angeordnet. Des Weiteren ist auf der Leiterplatte 8 ein Modulanschluss 10 angeordnet, der zum Verbinden des Servermoduls 1 mit einer Midplane des Trägerchassis dient. Über den Modulanschluss 10 wird unter anderem eine Betriebsspannung für das Servermodul 1 bereitgestellt.

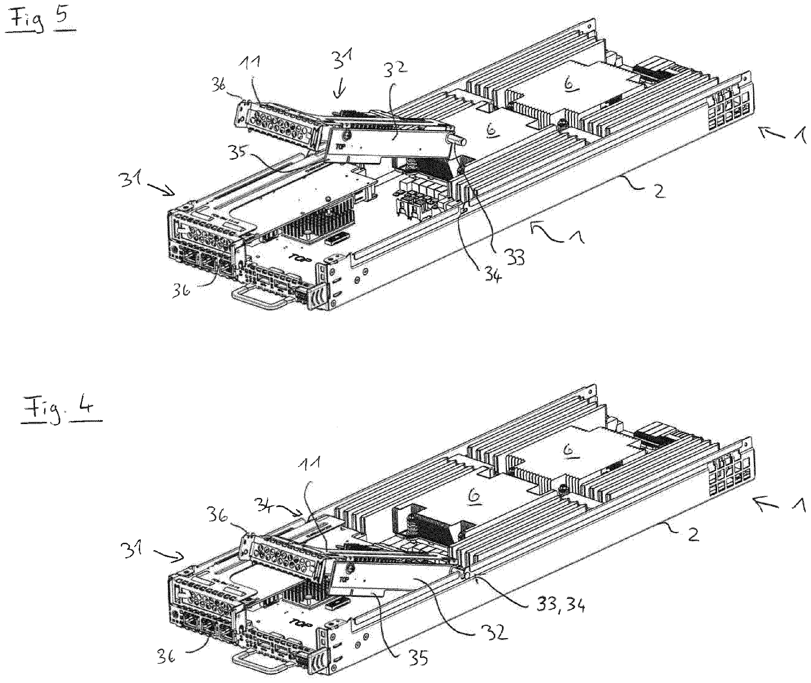

In der Figur 1 ist des Weiteren zu erkennen, dass in einem vorderen Bereich des halboffenen Chassis 2 zwei Trägerkomponenten 11 angeordnet sind. Jede der Trägerkomponenten 11 ist mit einer internen Erweiterungskarte 12 bestückt. Das Einsetzen beziehungsweise Herausnehmen der internen Erweiterungskarten 12 mittels der Trägerkomponenten 11 wird anhand der Figuren 4 und 5 im Detail beschrieben.

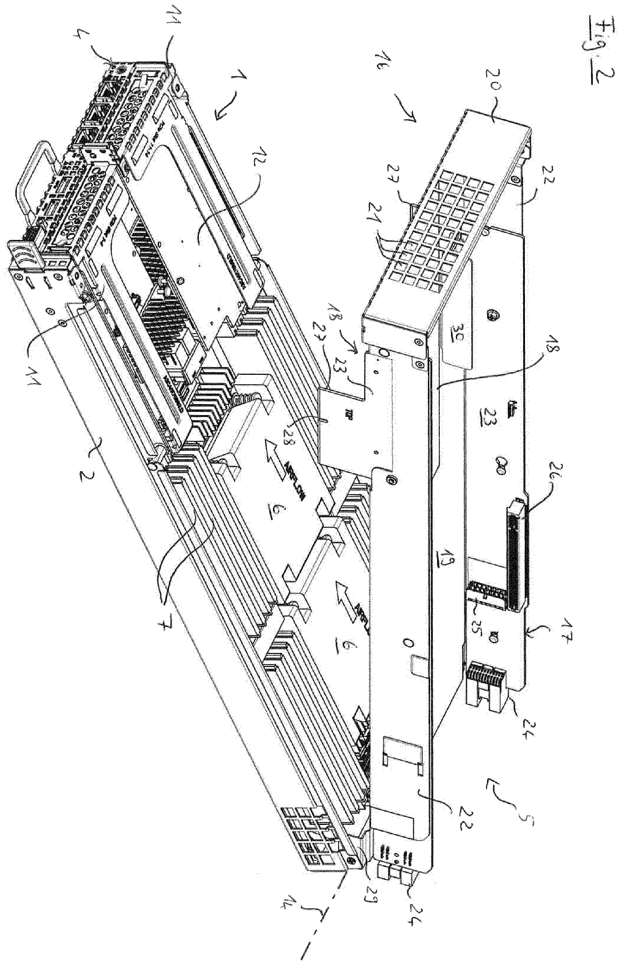

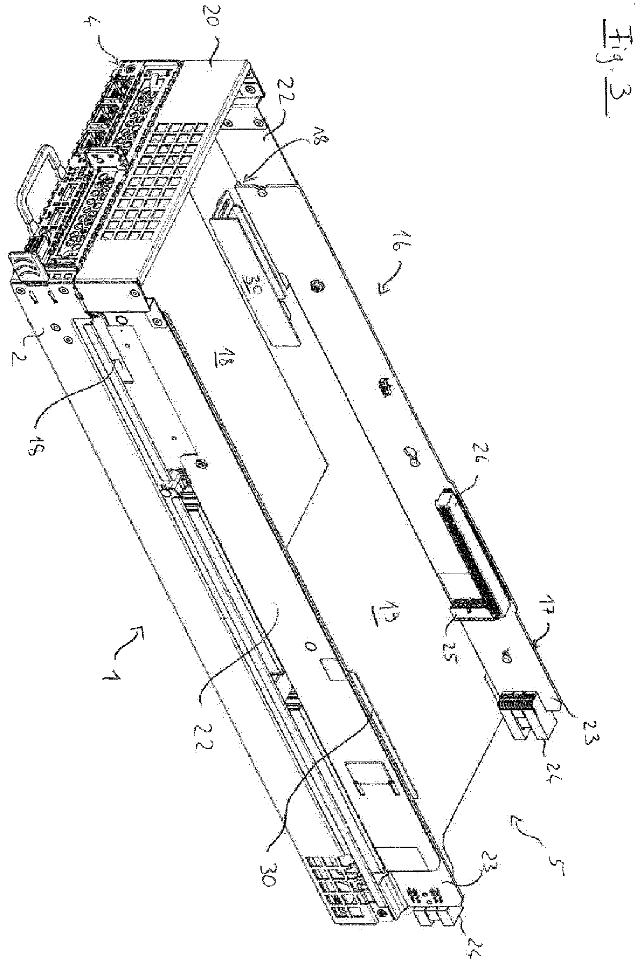

In der Figur 1 sind schließlich Befestigungspunkte zur Aufnahme eines in der Figur 1 nicht dargestellten, externen Erweiterungsmoduls zu erkennen. Hierzu dient eine zwischen den Seitenwänden 3 des Chassis 2 verschraubte Metallstange 13, die eine Drehachse 14 zur Aufnahme des Erweiterungsmoduls bildet. Des Weiteren sind im vorderen Bereich des Chassis 2 zwei Blechlaschen nach Innen aus den Seitenwänden 3 herausgebogen, die als Auflagefläche 15 für das Erweiterungsmodul dienen. Die Montage des Erweiterungsmoduls ist nachfolgend anhand der Figuren 2 und 3 beschrieben.

Figur 2 zeigt das Servermodul 1 gemäß Figur 1 mit dem daran angesetzten Erweiterungsmoduls 16. Auch das Erweiterungsmodul 16 weist ein halboffenes Chassis 17 auf. Das halboffene Chassis 17 ist ebenfalls als ein im Wesentlichen U-förmiges Stahlblechteil ausgestaltet. Dabei weist das Chassis 17 an seiner Unterseite 19 drei Öffnungen 18 auf, die wie später beschrieben unter anderem zur elektrischen Kontaktierung von Komponenten des Servermoduls 1 dienen.

Das halboffene Chassis 17 des Erweiterungsmoduls 16 weist an der Vorderseite 4 eine Abschirmblende 20 auf, die es nach vorne abschließt. Zur Kühlung der in dem Chassis 17 angeordneten Komponenten ist in die Abschirmblende 20 eine Vielzahl von Belüftungsöffnungen 21 eingebracht.

An zwei Seitenwänden 22 des Chassis 17 ist mittels Schrauben jeweils eine zweite Leiterplatte 23 befestigt. Auf den zweiten Leiterplatten 23 sind verschiedene Steckverbinder angeordnet. Insbesondere weist jede der Leiterplatten 23 im hinteren Bereich einen Modulanschluss 24 zum Verbinden der Leiterplatten 23 mit einer Midplane eines Trägerchassis zur Stromversorgung auf. Des Weiteren ist ein Stromversorgungsanschluss 25 sowie ein Steckverbinder 26 auf jeder der Leiterplatte 23 angeordnet. Die Steckverbinder 26 sind als PCIe-Anschlüsse ausgeführt und dienen zur elektrischen und mechanischen Aufnahme von in der Figur 2 nicht dargestellten, externen Erweiterungskarten in dem Erweiterungsmodul 16. Beispielsweise können in dem Erweiterungsmodul 16 zwei besonders leistungsfähigen Erweiterungskarten, wie insbesondere so genannten High-Performance-Computing-Karten beziehungsweise Grafik- oder Array-Coprozessor-Karten, aufgenommen und über die Stromversorgungsanschlüsse 25 unabhängig von dem Servermodul 1 mit einer Betriebsspannung versorgt werden.

Um eine Datenverbindung zwischen den in den Steckverbindern 26 aufgenommenen Erweiterungskarten und dem Servermodul 1 herzustellen, ragen die Leiterplatte 23 durch jeweils eine der Öffnungen 18 nach unten über das halboffene Chassis 17 hinaus. Am unteren Ende der Leiterplatte 23 sind so genannte Goldfingerkontakte vorgesehen, die zusammen einen Gegensteckverbinder 27 zum Einstecken in einen in der Figur 2 verdeckten Steckverbinder der ersten Leiterplatte 8 des Servermoduls 1 bilden. Neben den eigentlichen elektrischen Anschlüssen weist der Gegensteckverbinder 27 eine als Schlitz ausgeführte Kodierung 28 auf, die eine korrekte Positionierung der einzelnen Kontakte sicherstellt.

Der Gegensteckverbinder 27 befindet sich in relativ großem räumlichen Abstand von der durch die Metallstange 13 gebildeten Drehachse 14. Auf diese Weise ist gewährleistet, dass beim Verschwenken des Erweiterungsmoduls 16 gegenüber dem Servermodul 1 der Gegensteckverbinder 27 mit einem sehr kleinen Winkel in den entsprechenden Steckverbinder in Form eines Platinenseitensteckers der ersten Leiterplatte 8 eintaucht. Dieser Winkel ist so klein, dass er im Bereich der Toleranzen des Platinenseitensteckers liegt. Dementsprechend können die zweiten Leiterplatten 23 durch Ansetzen von am hinteren Ende des halboffenen Chassis 17 des Erweiterungsmoduls 16 angeordneten Aufnahmeschuhen 29 an die Metallstange 13 und nachfolgendes Drehen des Erweiterungsmoduls 16 um die Drehachse 14 mit der ersten Leiterplatte 8 des Servermoduls 1 verbunden werden.

Im vollständig verschwenkten Zustand berühren sich dabei Auflageflächen des Chassis 17 des Erweiterungsmoduls mit den Auflageflächen 15 des Chassis 2 des Servermoduls 1. Dieser Zustand ist in der Figur 3 dargestellt.

In den Figur 3 ist des Weiteren zu erkennen, dass in dem halboffenen Chassis 17 des Erweiterungsmoduls 16 zusätzliche zwei Befestigungselemente 30 angeordnet sind, die zur mechanischen sicheren Festlegung von in den Steckverbindern 26 aufgenommenen Erweiterungskarten dienen. Im Ausführungsbeispiel ist das Erweiterungsmodul 16 zur Aufnahme von zwei zueinander verdreht angeordneter Erweiterungskarten eingerichtet. Insbesondere dient die Leiterplatte 23 an der linken Seitenwand 22 zur Aufnahme einer Erweiterungskarte mit einer Leiterplatte, deren Komponenten auf der Unterseite angeordnet sind. Umgekehrt dient die Leiterplatte 23, die an der rechten Seitenwand 22 festgelegt ist, zur Aufnahme einer Erweiterungskarte in umgekehrter Orientierung, das heißt mit den darauf angeordneten Komponenten an der Oberseite.

Obwohl dies in der Figur 3 nicht dargestellt ist, können die Erweiterungskarten schon vor Ansetzen und Verschwenken des Erweiterungsmoduls 16 in die Steckverbinder 26 aufgenommen werden. Somit ist es möglich, ein vorkonfektioniertes Erweiterungsmodul 16 mitsamt darin aufgenommenen Erweiterungskarten durch gewinkeltes Ansetzen an dem Servermodul 1 und Verschwenken des Erweiterungsmoduls 16 in eine zu dem Servermodul 1 parallele Lage zu verbinden.

In den Figuren 4 und 5 ist der Ausbau einer der Trägerkomponenten 11 mit einer daran festgelegten internen Erweiterungskarte 12 dargestellt. Die in den Figuren 1, 4 und 5 ersichtliche Anordnungen 31 zur Festlegung der internen Erweiterungskarten 12 stellen dabei ein weiteres Ausführungsbeispiel der vorliegenden Erfindung dar.

Jede der Anordnungen 31 zur Festlegung einer der internen Erweiterungskarten 12 umfasst neben der Trägerkomponente 11 eine daran befestigte, dritte Leiterplatte 32. Die Trägerkomponenten 11 sind im Ausführungsbeispiel als in Form eines Metallwinkels mit nach Außen abstehende Metalllaschen ausgeführt, die auf den Seitenwänden 3 des halboffenen Chassis 2 aufliegen. Die dritte Leiterplatte 32 ist an zwei weiteren Metalllaschen der Trägerkomponente 11 verschraubt. Eine erste Schraubverbindung wird mittels einer gewöhnlichen Schraube hergestellt. Eine zweite Schraubverbindung wird mittels eines hervorstehenden Gewindebolzens 33 hergestellt. Der hervorstehende Gewindebolzen 33 hat einen Bolzenkopf mit einer umlaufenden Nut zur drehbar gelagerten Aufnahme in einem korrespondierenden Aufnahmeschuh 34 der Seitenwand 3. Mittels des Gewindebolzens 33 kann die Trägerkomponente 11 mit der daran befestigten dritten Leiterplatte 32 und der in einem Steckverbinder der Leiterplatte 32 aufgenommenen internen Erweiterungskarte 12 wie in der Figur 4 dargestellt aus dem Servermodul 1 heraus geklappt werden. Nachfolgend kann die Trägerkomponente 11 wie in der Figur 5 dargestellt, durch Lösen des Gewindebolzens 33 aus dem Aufnahmeschuh 34 herausgenommen werden.

Auch bei den Anordnungen 31 zur Festlegung der internen Erweiterungskarten 12 gemäß den Figuren 4 und 5 wurde der Abstand zwischen dem als Drehachse dienenden Gewindebolzen 33 und einem Gegensteckverbinder 35 in Form von Goldfingerkontakten möglichst groß gewählt. Auf diese Weise erfolgt die Herstellung beziehungsweise Trennung der elektrischen Verbindung zwischen den Goldfingerkontakten der dritten Leiterplatte 32 und einem korrespondierenden Steckverbinder der ersten Leiterplatte 8 beinahe senkrecht zur ersten Leiterplatte 8. Des Weiteren sind auch die zwei internen Erweiterungskarten 12 der linken beziehungsweise rechten Befestigungsanordnung 31 zueinander verdreht aufgenommen, so dass bei einer Erweiterungskarte 12 die Bestückungsseite nach oben, das heißt in dieselbe Richtung wie die Bestückungsseite der ersten Leiterplatte 8, weist und bei der anderen Erweiterungskarte 12 in die entgegengesetzte Richtung nach unten weist. Auf diese Weise ist eine Befestigung von standardkonformen internen Erweiterungskarten 12 mittels Slotwinkeln 36 an den diesbezüglich weitgehend spiegelsymmetrisch ausgeführten Trägerkomponenten 11 möglich.

Die unterschiedlichen Merkmale der beschriebenen Ausführungsbeispiele können in vielfältiger Weise miteinander kombiniert werden, um den jeweils angegebenen Vorteil zu erzielen. Insbesondere wäre auch die Befestigung der Trägerkomponenten 11 an einer durchgehenden Metallstange des ersten halboffenen Chassis 2 möglich. Umgekehrt könnten an dem zweiten halboffenen Chassis 17 Gewindebolzen zum Festlegen an entsprechenden Aufnahmeschuhen des ersten halboffenen Chassis 2 vorgesehen werden. Des Weiteren sind neben den beschriebenen PCIe-Steckverbindern sowie den Goldfinger- bzw. Platinenrandsteckern auch andere geeignete Steckverbinder möglich.

### Bezugszeichenliste

- 1: Servermodul
- 2: halboffener Chassis (des Servermoduls)
- 3: Seitenwand (des Servermoduls)
- 4: Vorderseite
- 5: Rückseite
- 6: Kühlvorrichtung
- 7: Speichermodul
- 8: (erste) Leiterplatte
- 9: Anschluss
- 10: Modulanschluss (des Servermoduls)
- 11: Trägerkomponente (für interne Erweiterungskarte)
- 12: (interne) Erweiterungskarte
- 13: Metallstange
- 14: Drehachse
- 15: Auflagefläche

- 16: Erweiterungsmodul
- 17: halboffenes Chassis (des Erweiterungsmoduls)
- 18: Öffnung
- 19: Unterseite
- 20: Abschirmblech
- 21: Belüftungsöffnung
- 22: Seitenwand (des Erweiterungsmoduls)
- 23: (zweite) Leiterplatte
- 24: Modulanschluss (des Erweiterungsmoduls)
- 25: Stromversorgungsanschluss
- 26: Steckverbinder
- 27: Gegensteckverbinder (der zweiten Leiterplatte)
- 28: Kodierung
- 29: Aufnahmeschuh (des Erweiterungsmoduls)
- 30: Befestigungselement
- 31: Anordnung
- 32: (dritte) Leiterplatte
- 33: Gewindebolzen
- 34: Aufnahmeschuh (des Servermoduls)
- 35: Gegensteckverbinder (der dritten Leiterplatte)
- 36: Slotwinkel

## Patentansprüche

1. Anordnung zur Festlegung wenigstens einer Erweiterungskarte (12), aufweisend:
- ein erstes halboffenes Chassis (2) zur Aufnahme einer ersten Leiterplatte (8) eines Servermoduls (1) mit wenigstens einem ersten Steckverbinder;
- eine Komponente zur Aufnahme wenigstens einer Erweiterungskarte (12), wobei die Komponente als Trägerkomponente (11) zur Aufnahme von wenigstens einer internen Erweiterungskarte (12) oder als zweites halboffenes Chassis (17) zur Aufnahme wenigstens einer externen Erweiterungskarte ausgestaltet ist, wenigstens einen Befestigungspunkt zur lösbaren und drehbaren Aufnahme der Komponente in beziehungsweise an dem ersten halboffenen Chassis (2) und wenigstens eine erste Auflagefläche zur Abstützung der Komponente an einer zweiten Auflagefläche (15) des ersten halboffenen Chassis (2) aufweist, die im Bereich gegenüberliegender Enden der Komponente angeordnet sind; und
- wenigstens eine an der Komponente befestigte zweite Leiterplatte (23, 32) mit wenigstens einem ersten Gegensteckverbinder (27, 35) zur elektrischen Kontaktierung des ersten Steckverbinders und wenigstens einem zweiten Steckverbinder (26) zur elektrischen Kontaktierung eines zweiten Gegensteckverbinders der internen beziehungsweise externen Erweiterungskarte (12), wobei der erste Gegensteckverbinder (27, 35) im Bereich des Endes der Komponente angeordnet ist, in dem sich die erste Auflagefläche befindet, so dass die zweite Leiterplatte (23, 32) durch Aufnahme und Verschwenken der Komponente um den Befestigungspunkt in Richtung der zweiten Auflagefläche (15) elektrisch mit der ersten Leiterplatte (8) verbunden wird.

2. Anordnung nach Anspruch 1, weiter umfassend wenigstens eine Drehachse (14) und wenigstens einen Aufnahmeschuh (29, 34) zur Aufnahme der Drehachse (14), wobei der erste Befestigungspunkt der Komponente durch Aufnahme der Drehachse (14) in dem Aufnahmeschuh (29, 34) drehbar an dem ersten halboffenen Chassis (2) festgelegt wird.

3. Anordnung nach Anspruch 1 oder 2, bei dem der erste Steckverbinder und der erste Gegensteckverbinder (27, 35) als Kartenrandstecker bzw. als Goldfingerkontakte ausgestaltet sind.

4. Anordnung nach einem der Ansprüche 1 bis 3, bei dem die Komponente und/oder der zweite Steckverbinder (26) zur Aufnahme einer Erweiterungskarte (12) gemäß dem PCIe-Standard ausgestaltet sind.

5. Anordnung nach einem der Ansprüche 1 bis 4, bei dem die zweite Leiterplatte (23, 32) wenigstens einen dritten Steckverbinder zur Kontaktierung eines dritten Gegensteckverbinders einer dritten Leiterplatte zur Stromversorgung der wenigstens einen Erweiterungskarte (12) unabhängig von der ersten Leiterplatte (8) aufweist.

6. Anordnung nach einem der Ansprüche 1 bis 5, bei dem im Bereich der ersten Auflagefläche eine Schraube zur Sicherung der Komponente an dem ersten halboffenen Chassis (2) angeordnet ist.

7. Anordnung nach einem der Ansprüche 1 bis 6, bei dem die Komponente als zweites halboffenes Chassis (17) ausgestaltet ist und das zweite halboffene Chassis (17) und die zweite Leiterplatte (23) zur Aufnahme der externen Erweiterungskarte im verschwenkten Zustand zumindest teilweise außerhalb des ersten halboffenen Chassis (2) angeordnet sind.

8. Anordnung nach Anspruch 7, bei dem die Komponente als U-förmiges Chassis (17) ausgestaltet ist, dass die wenigstens eine externe Erweiterungskarte zumindest teilweise umgibt.

9. Anordnung (31) nach einem der Ansprüche 1 bis 6, bei dem die Komponente als Trägerkomponente (11) ausgestaltet ist und die Trägerkomponente (11) und die zweite Leiterplatte (32) zur Aufnahme der internen Erweiterungskarte (12) in einem verschwenkten Zustand vollständig im Inneren des ersten halboffenen Chassis (2) angeordnet sind.

10. Serversystem mit einer Anordnung nach einem der Ansprüche 1 bis 8, aufweisend:
- ein Trägerchassis zur Aufnahme einer Mehrzahl von Modulen, insbesondere Servermodule (1) und Erweiterungsmodule (16);
- eine in dem Trägerchassis aufgenommene Leiterplatte zur elektrischen Kontaktierung der Mehrzahl von Modulen;
- wenigstens ein in dem Trägerchassis aufgenommenes Servermodul (1) mit einem ersten halboffenen Chassis (2); und
- wenigstens ein in dem Trägerchassis aufgenommenes Erweiterungsmodul (16) mit einem zweiten halboffenen Chassis (17);
- wobei in dem Erweiterungsmodul (16) wenigstens eine externe Erweiterungskarte für das Servermodul (1) angeordnet ist und das zweite halboffene Chassis (17) des Erweiterungsmoduls (16) verschwenkbar an dem ersten halboffenen Chassis (2) des Servermoduls (1) festgelegt ist.

## Claims

1. Assembly for securing at least one expansion card (12), comprising:
- a first half-open chassis (2) for receiving a first circuit board (8) of a server module (1) having at least one first plug connector;
- a component for receiving at least one expansion card (12), wherein the component is configured as a carrier component (11) for receiving at least one internal expansion card (12) or as a second half-open chassis (17) for receiving at least one external expansion card, comprises at least one securing point for rotatably and releasably receiving the component in or on the first half-open chassis (2) and at least one first bearing surface for supporting the component on a second bearing surface (15) of the first half-open chassis (2), which are arranged in the region of opposite ends of the component; and
- at least one second circuit board (23, 32) secured to the component having at least one first mating plug connector (27, 35) for electrically contacting the first plug connector and at least one second plug connector (26) for electrically contacting a second mating plug connector of the internal or external expansion card (12), wherein the first mating plug connector (27, 35) is arranged in the region of the end of the component where the first bearing surface is located, so that the second circuit board (23, 32) is electrically connected to the first circuit board (8) by receiving and pivoting the component about the securing point in the direction of the second bearing surface (15).

2. Assembly according to claim 1, further comprising at least one axis of rotation (14) and at least one receiving shoe (29, 34) for receiving the axis of rotation (14), wherein the first securing point of the component is rotatably secured to the first half-open chassis (2) by receiving the axis of rotation (14) in the receiving shoe (29, 34).

3. Assembly according to claim 1 or 2, in which the first plug connector and the first mating plug connector (27, 35) are configured as card edge connectors or as gilded pin contacts.

4. Assembly according to one of claims 1 to 3, in which the component and/or the second plug connector (26) are designed for receiving an expansion card (12) according to the PCIe standard.

5. Assembly according to one of claims 1 to 4, in which the second circuit board (23, 32) comprises at least one third plug connector for the contacting of a third mating plug connector of a third circuit board for the power supply of the at least one expansion card (12) independently from the first circuit board (8).

6. Assembly according to one of claims 1 to 5, in which a screw for securing the component on the first half-open chassis (2) is arranged in the region of the first bearing surface.

7. Assembly according to one of claims 1 to 6, in which the component is configured as second half-open chassis (17) and the second half-open chassis (17) and the second circuit board (23) are arranged at least partially outside the first half-open chassis (2) for receiving the external expansion card in the pivoted state.

8. Assembly according to claim 7, in which the component is designed as a U-shaped chassis (17) that surrounds the at least one external expansion card at least partially.

9. Assembly (31) according to one of claims 1 to 6, in which the component is configured as a carrier component (11), and the carrier component (11) and the second circuit board (32) are arranged completely inside the half-open chassis (2) for receiving the internal expansion card (12) in a pivoted state.

10. Server system having an assembly according to one of claims 1 to 8, comprising:
- a carrier chassis for receiving a plurality of modules, in particular server modules (1) and expansion modules (16);
- a circuit board, received in the carrier chassis, for electrically-contacting the plurality of modules;
- at least one server module (1), received in the carrier chassis, with a first half-open chassis (2);
and
- at least one expansion module (16), received in the carrier chassis, with a second half-open chassis (17);
- wherein at least one external expansion card for the server module (1) is arranged in the expansion module (16), and the second half-open chassis (17) of the expansion module (16) is pivotably secured to the first half-open chassis (2) of the server module (1).

## Revendications

1. Agencement pour fixer au moins une carte d'extension (12), présentant :
- un premier châssis semi-ouvert (2) destiné à recevoir un premier circuit imprimé (8) d'un module de serveur (1) avec au moins un premier connecteur ;
- un composant destiné à recevoir au moins une carte d'extension (12), le composant étant conçu comme un composant porteur (11) destiné à recevoir au moins une carte d'extension interne (12) ou comme un deuxième châssis semi-ouvert (17) destiné à recevoir au moins une carte d'extension externe; présentant au moins un point de fixation destiné à la réception, de manière amovible et à pouvoir tourner, le composant dans voire sur le premier châssis semi-ouvert (2), et au moins une première surface d'appui destinée à étayer le composant sur une deuxième surface d'appui (15) du premier châssis semi-ouvert (2), qui sont disposées au niveau des extrémités opposées du composant ; et
- au moins un deuxième circuit imprimé (23, 32) fixé sur le composant avec au moins un premier connecteur antagoniste (27, 35) pour une mise en contact électrique du premier connecteur et au moins un deuxième connecteur (26) pour une mise en contact électrique d'un deuxième connecteur antagoniste de la carte d'extension (12) interne voire externe, le premier connecteur antagoniste (27, 35) étant disposé dans la zone de l'extrémité du composant où se trouve la première surface d'appui de telle sorte que le deuxième circuit imprimé (23, 32) soit relié électriquement avec le premier circuit imprimé (8) par réception et par pivotement du composant autour le point de fixation en direction de la deuxième surface d'appui (15) .

2. Agencement selon la revendication 1, comprenant en outre au moins un axe de rotation (14) et au moins une patin de réception (29, 34) destiné à recevoir l'axe de rotation (14), le premier point de fixation du composant étant fixé, de manière à pouvoir tourner, sur le premier châssis semi-ouvert (2) par recevoir de l'axe de rotation (14) dans le patin de réception (29, 34).

3. Agencement selon la revendication 1 ou 2, dans lequel le premier connecteur et le premier connecteur antagoniste (27, 35) sont conçus comme des connecteurs de bord de carte voire des contacts plaqué or.

4. Agencement selon l'une quelconque des revendications 1 à 3, dans lequel le composant et/ou le deuxième connecteur (26) sont conçus pour recevoir une carte d'extension (12) conformément au standard PCIe.

5. Agencement selon l'une quelconque des revendications 1 à 4, dans lequel le deuxième circuit imprimé (23, 32) présente au moins un troisième connecteur pour la mise en contact d'un troisième connecteur antagoniste d'un troisième circuit imprimé pour l'alimentation en énergie électrique de l'au moins une carte d'extension (12) indépendamment du premier circuit imprimé (8).

6. Agencement selon l'une quelconque des revendications 1 à 5, dans lequel une vis pour bloquer le composant sur le premier châssis semi-ouvert (2) est disposée dans la zone de la première surface d'appui.

7. Agencement selon l'une quelconque des revendications 1 à 6, dans lequel le composant est conçu comme un deuxième châssis semi-ouvert (17) et le deuxième châssis semi-ouvert (17) et le deuxième circuit imprimé (23) destinés à recevoir la carte d'extension externe à l'état pivoté sont disposés, au moins en partie, en-dehors du premier châssis semi-ouvert (2).

8. Agencement selon la revendication 7, dans lequel le composant est réalisé sous forme d'un châssis en forme de U (17), lequel entoure, au moins en partie, l'au moins une carte d'extension externes.

9. Agencement (31) selon l'une quelconque des revendications 1 à 6, dans lequel le composant est conçu comme un composant porteur (11) et le composant porteur (11) et le deuxième circuit imprimé (32) destinés à recevoir la carte d'extension interne (12) à l'état basculé sont disposés entièrement à l'intérieur du premier châssis semi-ouvert (2) .

10. Système de serveur ayant un agencement selon l'une quelconque des revendications 1 à 8, comprenant :
- un châssis porteur destiné à recevoir une pluralité de modules, en particulier des modules de serveur (1) et des modules d'extension (16) ;
- un circuit imprimé logé dans le châssis porteur pour une mise en contact électrique de la pluralité des modules ;
- au moins un module de serveur (1) avec un premier châssis semi-ouvert (2) logé dans le châssis porteur ; et
- au moins un module d'extension (16) avec un deuxième châssis semi-ouvert (17) logé dans le châssis porteur ;
- au moins une carte d'extension externe pour le module de serveur (1) étant disposée dans le module d'extension (16) et le deuxième châssis semi-ouvert (17) du module d'extension (16) étant fixé sur le premier châssis semi-ouvert (2) du module de serveur (1) de manière à pouvoir pivoter.
